# EUROPEAN PATENT APPLICATION

(11) **EP 1 712 656 A1**
(43) Date of publication of application: **18.10.2006**
(21) Application number: 06252003.6
(22) Date of filing: 11.04.2006
(51) Int. Cl.: C23C 16/44, C23C 16/18

(54) **Metal-containing compound purification**

(30) Priority: 12.04.2005 US 670596 P
(71) Applicant: Rohm and Haas Electronic Materials, L.L.C., Marlborough, Massachusetts 01752 (US)
(72) Inventor: Shenai-Khatkhate, Deodatta Vinayak, Danvers, Massachusetts 01923 (US); Power, Michael B., Newburyport, Massachusetts 01950 (US)
(74) Representative: Kent, Venetia Katherine

(57) **Abstract**

A process of purifying metal-containing compounds employing continuous extraction is provided. The metal-containing compounds are provided in high purity and are suitable for use in depositing metal films, particularly thin metal films used in electronic devices.

## Description

### Background of the Invention

The present invention relates to the field of metal-containing compounds. In particular, this invention relates to the purification of organometallic compounds useful for depositing metal films.

Metal-containing compounds are used in a variety of applications, such as sources for growing thin metal films. One use of such compounds is in the manufacture of electronic devices such as semiconductors. Many semi-conducting materials are manufactured using well-established deposition technologies that employ ultrapure metalorganic compounds, e.g. Metalorganic Vapor Phase Epitaxy ("MOVPE"), Metalorganic Molecular Beam Epitaxy ("MOMBE"), Metalorganic Chemical Vapor Deposition ("MOCVD") and Atomic Layer Deposition ("ALD"). To be useful in these processes the organometallic compounds must be free from contaminants and/or deleterious impurities. If not removed, such impurities present in the organometallic sources can cause adverse effects on the electronic and/or optoelectronic properties of electronic devices.

Recently, innovative indium-containing compound semiconductor compositions that also contain high levels of aluminum, such as AlGaInP, have been developed which are particularly useful for the production of high brightness light emitting diodes ("HB-LED") which consume less power than conventional LEDs and may be produced in a variety of colors. The consistency in performance of HB-LEDs is dependent on the highest purity of the sources used to form the semi-conducting layers. The performance of such layers is particularly sensitive to trace levels of metallic impurities such as silicon, germanium and tin that can be conceivably present in the sources, and oxygen-containing species which may be present in the source materials and which may be incorporated into the layers. Typical oxygen-containing impurities which may be present in the organometallic sources include ethers (used as solvents), metal alkyl-ether adducts, alkyl metal alkoxides, metal trialkoxide and metal oxide particles.

The metallic and oxygen containing impurities may be introduced into the organometallic compounds from various sources, such as from the raw materials used, solvents used, by inadvertent contamination of air into the source bubbler via leaks or failure in cylinder integrity, and by the carrier gas and environment used in the transportation of the precursor vapors to a deposition chamber. These metallic and/or oxygen containing species present in the organometallic compound are transported along with the organometallic compound into the reactor where these impurities are decomposed to release metallic impurities and/or oxygen that are incorporated into the deposited layers. The performance of any semi-conductor device fabricated from such a contaminated layer is severely degraded. The concern for high purity and consistency in performance has become more critical because of the stringent performance specifications required by certain markets where HB-LEDs and white LEDs are used.

Numerous techniques have been employed to purify organometallic compounds, such as. fractional distillation, sublimation, crystallization, adduct purification, and zone refining, all with limited success, especially in the purification of trimethyl indium, trimethyl aluminum, trimethyl gallium and dicyclopentadienyl magnesium. U.S. Pat. No. 3,229,469 (Katon) discloses the preparation of reaction products of tetracyanoethylene with metal salts. Colored impurities are removed from such reaction products by Soxhlet extraction using amine solvents such as pyridine. The reaction product was not at all soluble in the extraction solvent used.

There remains a need for a process that consistently provides high purity metal-containing compounds, particularly organometallic compounds, with very low levels of metallic and oxygen-containing impurities.

### Summary of the Invention

The present invention provides a process for purifying metal-containing compounds including the steps of: providing a composition including an amount of metal-containing compound and an impurity; subjecting the composition to a continuous extraction using an amount of solvent; and collecting the metal-containing compound from the solvent; wherein the metal-containing compound is sparingly soluble in the solvent and wherein the amount of solvent is insufficient to completely dissolve the amount of metal-containing compound.

### Detailed Description of the Invention

As used throughout this specification, the following abbreviations shall have the following meanings, unless the context clearly indicates otherwise: °C = degrees centigrade; g = grams; L = liters; mL = milliliter; Pa = Pascal; ppm = parts per million; and mtorr = millitorr. "Aliphatic hydrocarbon" includes linear aliphatic hydrocarbon and cycloaliphatic hydrocarbon. "Alkyl" includes linear, branched and cyclic alkyl. Likewise, "alkenyl" and "alkynyl" include linear, branched and cyclic alkenyl and alkynyl, respectively. "Halogen" refers to fluorine, chloride, bromine and iodine. As used herein, "CVD" is intended to include all forms of chemical vapor deposition such as MOCVD, metalorganic vapor phase epitaxy ("MOVPE"), organometallic vapor phase epitaxy ("OMVPE"), organometallic chemical vapor deposition "(OMCVD") and remote plasma chemical vapor deposition ("RPCVD").

The articles "a" and "an" refer to the singular and the plural. Unless otherwise noted, all amounts are percent by weight and all ratios are molar ratios. All numerical ranges are inclusive and combinable in any order except where it is clear that such numerical ranges are constrained to add up to 100%.

The present invention provides a process for purifying metal-containing compounds including the steps of: providing a composition including an amount of metal-containing compound and an impurity; subjecting the composition to a continuous extraction using an amount of solvent; and collecting the metal-containing compound from the solvent; wherein the o metal-containing compound is sparingly soluble in the solvent and wherein the amount of solvent is insufficient to completely dissolve the amount of metal-containing compound. The composition includes the metal-containing compound and one or more impurities. The impurities may be metallic impurities such as silicon, germanium, tin, iron, manganese, and aluminum. Other impurities that may be present are oxygen-containing impurities such as ethers (used as solvents), metal alkyl-ether adducts, alkyl metal alkoxides, metal trialkoxide and metal oxide particles.

A variety of metal-containing compounds may be purified by the present process. Such metal-containing compounds are typically solids at the temperature employed in the extraction process. Liquid metal-containing compounds that are readily solidified can be used in the present process. For example, trimethyl aluminum (melting point approximately 15° C) can be used in the present process by using an extraction chamber that maintains the trimethyl aluminum at or below its melting temperature during the extraction process. Suitable metal-containing compounds include, without limitation, Group IIA compounds, metallocenes, beta-diketonates, Group IIIA compounds, Group IVA compounds, Group VA compounds and transition metal compounds. Group IIA compounds include magnesium compounds such as dicyclopentadienyl magnesium. Typical Group IIIA compounds include, but are not limited to: halogenated Group IIIA compounds such as gallium tribromide, gallium trichloride, aluminum trichloride, indium tribromide and indium trichloride; mono-, di- and tri-alkyl Group IIIA compounds; mono-, di- and tri-alkenyl Group IIIA compounds; and mono-, di- and tri-alkynyl Group IIIA compounds. Group IVA compounds include, without limitation: halogenated Group IVA compounds such as germanium tetrachloride and germanium tetrabromide; mono-, di-, tri- and tetra-alkyl Group IVA compounds such as tertiartbutyl trichloro germane; mono-, di-, tri- and tetra-alkenyl Group IVA compounds; mono-, di-, tri- and tetra-alkynyl Group IVA compounds; and mono-, di-, tri- and tetra-aryl Group IVA compounds such as triphenyl germanium chloride. Particularly suitable Group IVA compounds are those containing germanium and tin. Suitable transition metal compounds include, without limitation, organometallic compounds of nickel, platinum, ruthenium, hafnium, zirconium, zinc and cadmium. Suitable alkyl groups typically have from 1 to 10 carbon atoms, more typically from 1 to 6 carbon atoms and still more typically from 1 to 4 carbon atoms. The alkenyl and alkynyl groups typically have from 2 to 10 carbon atoms and more typically from 2 to 6 carbon atoms. Exemplary metal-containing compounds include dicyclopentadienyl magnesium, trimethyl indium, triethyl indium, di-isopropyl methyl indium, trimethyl gallium, triethyl gallium, methylpyrrolidine alane, trimethyl aluminum, triethyl aluminum, tri-isobutyl aluminum and tri-tertiarybutyl aluminum. Other exemplary metal-containing compounds include, without limitation, dimethyl cadmium, cyclopentadienyl cadmium, cyclopentadienyl zinc, antimony trichloride and methyl antimony dichloride. In one embodiment, the metal-containing compound is an organometallic compound.

A variety of solvents are suitable for use in the present invention. Such solvents are selected such that they possess comparatively greater volatility than the solute (metal-containing compound), match well with the thermal stability of solute under the conditions of its use, and possess optimum solubility towards the solute to enable effective crystallization subsequent to extraction. The metal-containing compound is sparingly soluble in the solvent used in the present process. The term "sparingly soluble" means the metal-containing compound has a solubility of ≤ 0.05 mole per mole of solvent. Typically, the metal-containing compound has a solubility of ≤ 0.04 moles per mole of solvent and more typically ≤ 0.03 moles per mole of solvent.

Suitable solvents include aliphatic hydrocarbons. Exemplary aliphatic hydrocarbons include, without limitation, C₅-C₄₀ hydrocarbons such as pentane, hexane, heptane, octane, nonane, decane, dodecane, tetradecane, hexadecane, squalane, cyclopentane, cyclohexane, cycloheptane, cyclooctane and petroleum ethers. For example, when the metal-containing compound is trimethyl indium, particularly useful solvents include hexane, cyclopentane, cyclohexane, hexadecane and squalane. When the metal-containing compound is dicyclopentadienyl magnesium, particularly useful solvents include hexane, cyclohexane, dodecane and squalane. It will be appreciated by those skilled in the art that a mixture of solvents may be used. In one embodiment, the solvent is not an aromatic hydrocarbon as the metal-containing compounds are often too soluble in such solvents. In another embodiment, the solvent is not an ether-containing solvent as the metal-containing compounds are too soluble in such solvents and such solvents can create strong coordinate complexes with the metal-containing compound.

The amount of solvent employed in the present process depends upon the particular metal-containing compound to be purified and the amount of such compound. Typically, a fixed amount of solvent is used in the extraction step. The amount of the solvent is insufficient to completely dissolve the amount of metal-containing compound in the composition. In this way, the purified metal-containing compound precipitates (crystallizes) from the extraction solvent during the continuous extraction step.

Any suitable continuous extraction step may be used in the present invention. An exemplary continuous extraction step is Soxhlet extraction. By "continuous extraction" it is meant that the composition including the metal-containing compound and the impurity are continuously exposed to the extraction solvent for a period of time. The particular time will depend upon the solvent, the metal-containing compound and the impurity to be removed.

In general, the composition including the metal-containing compound and the impurity are added to a suitable extraction vessel. The composition may optionally be ground into small particles before being placed in the extraction vessel. In the case of a Soxhlet extractor, the composition is added to an extraction thimble. A variety of thimbles may be used. In one embodiment the thimble is porous stainless steel. The thimble is then placed in the extraction chamber of the Soxhlet extractor.

The extraction chamber is added to an continuous extraction apparatus, which typically includes a boiling vessel, the extraction vessel and a condenser. The solvent is added to the boiling vessel and refluxed. The solvent evaporates and rides up into the condenser where it is condensed into a liquid. This liquid drips into the extraction chamber containing the metal-containing compound. The metal-containing compound is extracted by repetitious washing or percolation with the solvent under reflux ("continuous extraction").

The extraction chamber is strategically designed so that when the solvent surrounding the composition exceeds a certain level it overflows and transports down into the boiling vessel, carrying with it an amount of the metal-containing compound in solution. The process of extraction continues each time bringing down more and more of the metal-containing compound into the boiling vessel and leaving behind insoluble impurities such as metal oxides of one or more of silicon, germanium or tin.

At the end of the extraction process, which may last a few hours, the flask containing the solvent and metal-containing compound is removed from the extraction apparatus under inert atmosphere. At this stage, metal-containing compound is already crystallized and forms the greater portion of the mass. The solvent in the boiling vessel is then removed by a suitable technique such as decantation and/or filtration. Trace amounts of solvent may be removed by a suitable technique such as vacuum distillation and the crystals are optionally further purified such as by washing and or vacuum sublimation. In one embodiment, the crystallized metal-containing compound obtained may optionally be sublimed involving a short fore-cut to ensure complete removal of the solvent. In a further optional step, a funnel is used on top of the extraction chamber so as to recover the solvent at the end of the extraction by closing a valve between the funnel and the extraction chamber. Also optionally, the extraction chamber can be fritted, i.e. with a porous bottom, to facilitate extraction with filtration.

The purified metal-containing compound obtained from the present process may optionally be further purified by any suitable technique, such as by recrystallization, sublimation, and distillation including fractional distillation.

In an alternate embodiment, the extraction apparatus may optionally include a filtration means disposed between the extraction chamber and the boiling vessel. In this embodiment, solvent containing the metal-containing compound exiting the extraction chamber is first directed to the filtration means and then exits the filtration means and returns to the boiling vessel. The filtration means may be a simple condensing unit equipped with a filter, porous plate, fit or other suitable means for removing crystallized metal-containing compound. As the solvent enters the filtration means, it is exposed to conditions sufficient to crystallize the metal-containing compound. Suitable condition include one or more of cooling the solvent to induce crystallization, evaporating, such as flash evaporating, the solvent to crystallize the metal-containing compound, and exposing the solvent to seed crystals of the metal-containing compound to induce crystallization of the dissolved metal-containing compound. After the metal-containing compound is removed from the solvent, the solvent may then be returned to the boiling vessel.

Impurities in the composition that are not soluble in the extraction solvent remain in the extraction vessel. Impurities that are soluble in the extraction solvent generally remain in the extraction solvent after crystallization of the metal-containing compound. The present process provides a purification process employing both an extraction step and a crystallization step in a single process.

The present invention offers several advantages over conventional purification techniques, namely it (a) does not require the use of large quantities of solvent (b) does not require frequent solvent replacement, (c) removes by extraction a relatively greater proportion of metal-containing compound than impurity, (d) returns almost all amount of the metal-containing compound by crystallization, and (e) can work unattended or with minimum attention of operators for long periods. The present invention provides a significant savings of resources as compared to conventional purification techniques.

The following examples are expected to illustrate further various aspects of the present invention, but are not intended to limit the scope of the invention in any aspect. All manipulations are performed in an inert atmosphere, typically under an atmosphere of dry nitrogen.

### Example 1: Di-(cyclopentadienyl)magnesium (Cp₂Mg) Purification

In a glove bag, under an atmosphere of nitrogen, unpurified Cp₂Mg (120 g) was charged into the extraction vessel. The complete apparatus including solvent condenser was assembled with the Cp₂Mg charge included. The apparatus was then removed from the glove bag, and immediately connected to a nitrogen source in a fume hood.

Separately hexane (1.5L) was degassed by bubbling nitrogen through the solvent in a 3L 3-necked round bottomed flask. A dry ice condenser was used to retain any entrained hexane. The degassing was continued for 45 minutes. Once the degassing was complete, the dry ice condenser was removed and the extractor apparatus with condenser was attached to the flask under a continuous purge of nitrogen.

The hexane was brought to reflux and the extraction cycle began. The time for continuous extraction of the Cp₂Mg was 10 hours. During this time, all the Cp₂Mg was extracted leaving an insoluble beige colored residue behind in the extractor. The purified Cp₂Mg was then deposited from the hexane solvent upon cooling of the solvent to room temperature.

The bulk of the hexane solvent was removed from the deposited Cp₂Mg by siphoning technique. Any remaining hexane was then removed under vacuum (50-100 mtorr or 6.66 to 13.33 Pa) and was trapped in a liquid nitrogen cooled trap. Approximately 30 mL Hexane was found to be collected in the liquid nitrogen cooled trap. This resulted in solvent-free and white crystalline Cp₂Mg (97g, 80.83%). The absence of organic impurities at low ppm levels was confirmed by using Fourier Transform - Nuclear Magnetic Resonance Spectroscopy and comparison with authentic pure Cp₂Mg sample. The Spark Source Mass Spectrometry (SSMS) analyses for typical donor metal impurities present in the starting material and pure product are shown in Table below.

| **Element (ppm)** | **Before Extraction** | **After Extraction** |
|---|---|---|
| Si | 6.0 | 3 |
| Fe | 2.0 | 1 |
| Mn | 2.0 | 0.4 |
| Al | 3.0 | 0.6 |
| Ga | 0.4 | 0.5 |
| W | ND | ND |
| Ru | ND | ND |
| Mo | <0.5 | <0.5 |

### Example 2: Trimethyl indium (TMI) Purification

In a glove box, under an atmosphere of nitrogen, unpurified TMI (500 g) is charged into the extraction chamber of the vessel. The extraction setup is then assembled under nitrogen with solvent condenser and the boiler flask. Degassed pentane (1.0 L) is then added into the boiler flask under a continuous purge of nitrogen. The pentane is then brought to reflux so as to begin the continuous extraction for a period of 10 - 12 hours uninterrupted. Most of the TMI is expected to be extracted leaving behind an insoluble residue in the extractor chamber. The purified TMI is collected in the boiler flask and is then re-crystallized from its supersaturated pentane solution upon cooling to room temperature. The bulk of the pentane solvent from the crystalline mass is removed by decanting. The crystals are then washed with fresh pre-cooled pentane solvent, and residual trace pentane is expected to be removed under vacuum and is trapped in a cooled trap. Pure TMI, i.e. pentane-free and white crystalline product, is expected to be obtained in high yield. The absence of organic and oxygenated impurities at low ppm levels is expected. The metallic impurities are expected to be below the detection limits of Inductively Coupled Optical Emission Spectrometry (ICPOES).

### Example 3: Trimethyl aluminum (TMA) Purification

In a glove box, under an atmosphere of nitrogen, unpurified and frozen TMA (600 g) is charged into the jacketed extraction chamber of the vessel. The extraction setup is then assembled under nitrogen with solvent condenser and the boiler flask. The TMA is maintained as solid crystals (melting range of 15 °C to 17 °C) by circulating coolant (at 0° to 5° C) in the jacket of the extraction chamber. Degassed pentane (1.0 L) is then added into the boiler flask under a continuous purge of nitrogen. The pentane is then brought to reflux so as to begin the continuous extraction for a period of 10 - 12 hours uninterrupted. Most of the TMA is expected to be extracted leaving behind an insoluble residue and particulates of alumina in the extractor chamber. The purified TMA is collected in the boiler flask and is then allowed to cool to 10 °C so as to affect the crystallization of TMA from its supersaturated solution. The bulk of the pentane solvent from the crystalline mass is removed by decanting. The crystals are then washed with fresh pre-cooled pentane solvent (5 °C to 10 °C), and residual trace pentane is expected to be removed under vacuum and is trapped in a liquid nitrogen cooled trap. Pure and frozen TMA, i.e. pentane-free and white crystalline product, is expected to be obtained in high yield. The absence of organic and oxygenated impurities at low ppm levels is expected. The metallic impurities are expected to be below the detection limits of Inductively Coupled Optical Emission Spectrometry (ICPOES) analysis.

### Example 4: Methylpyrrolidine-Alane (MPA) Purification

In a glove box, under an inert atmosphere of nitrogen, unpurified and frozen MPA (500 g) is charged into the jacketed extraction chamber of the vessel. The extraction setup is then assembled under nitrogen with solvent condenser and the boiler flask. The MPA is maintained as a solid crystalline compound by circulating coolant (at 10 °C to 15 °C) in the jacket of the extraction chamber. Degassed pentane (1.0 L) is then added into the boiler flask under a continuous purge of nitrogen. The pentane is then brought to reflux so as to begin the continuous extraction for a period of 8 - 10 hours uninterrupted. Most of the MPA is expected to be extracted leaving behind an insoluble residue and particulates of alumina in the extractor chamber. The purified MPA is collected in the boiler flask and is then allowed to cool to 10 °C so as to affect the crystallization of MPA from its supersaturated solution. The bulk of the pentane solvent from the crystalline mass is removed by decanting. The crystals are then washed with fresh pre-cooled pentane solvent (5 °C to 10 °C), and residual trace pentane is expected to be removed under vacuum and is trapped in a liquid nitrogen cooled trap. Pure and frozen MPA, i.e. pentane-free and white crystalline product, is expected to be obtained in high yield. The absence of organic and oxygenated impurities at low ppm levels is expected. The metallic impurities are expected to be below the detection limits of Inductively Coupled Optical Emission Spectrometry (ICPOES) analysis.

### Examples 5-14

Various other metal-containing compounds are expected to be purified according to the procedures of Examples 1-4. The particular metal-containing compounds and expected suitable extraction solvents are reported in the following table.

| **Example** | **Compound** | **Extraction Solvent** | **Procedure** |
|---|---|---|---|
| 5 | Tetrakis(dimethylamido)hafnium, TDMAHf | Petroleum Ether (20/40) | Example 4 |
| 6 | Tetrakis(dimethylamido)zirconium, TDMAZr | Petroleum Ether (40/60) | Example 2 |
| 7 | Bis(methylcyclopentadienyl)nickel, (MCp)₂Ni | Pentane | Example 4 |
| 8 | Bis(ethylcyclopentadienyl)ruthenium, (ECp)₂Ru | Pentane | Example 3 |
| 9 | Cyclopentadienyl(trimethyl)platinum, (Cp)Me₃Pt | Pentane | Example 4 |
| 10 | Pentakis(dimethylamido)titanium, PDMAT | Cyclohexane | Example 1 |
| 11 | Gallium trichloride | Hexane | Example 2 |
| 12 | Aluminum hexafluoroacetylacetonate | Cyclopentane | Example 2 |
| 13 | Triphenylgermanium chloride | Petroleum Ether (40/60) | Example 1 |
| 14 | Tertiarybutyl trichlorogermane | Hexane | Example 1 |

## Claims

1. A process for purifying metal-containing compounds comprising the steps of: providing a composition comprising an amount of metal-containing compound and an impurity; subjecting the composition to a continuous extraction using an amount of solvent; and collecting the metal-containing compound from the solvent; wherein the metal-containing compound is sparingly soluble in the solvent and wherein the amount of solvent is insufficient to completely dissolve the amount of metal-containing compound.

2. The process of claim 1 wherein the metal-containing compound is chosen from Group IIA compounds, metallocenes, beta-diketonates, Group IIIA compounds, Group IVA compounds, Group VA compounds and transition metal compounds.

3. The process of claim 1 wherein the metal-containing compound is chosen from dicyclopentadienyl magnesium, trimethyl indium, triethyl indium, di-isopropyl methyl indium, trimethyl gallium, triethyl gallium, methylpyrrolidine alane, trimethyl aluminum, triethyl aluminum, tri-isobutyl aluminum and tri-tertiarybutyl aluminum.

4. The process of claim 1 wherein the metal-containing compound has a solubility of ≤ 0.05 mole per mole of solvent.

5. The process of claim 4 wherein the solubility of the metal-containing compound is ≤ 0.03 mole per mole of solvent.

6. The process of claim 1 wherein the collecting step comprises a step chosen from filtering and decanting.

7. The process of claim 1 further comprising the step of subjecting the collected metal-containing compound to a step chosen from recrystallization, distillation and sublimation.

8. The process of claim 1 wherein the continuous extraction step is performed using a Soxhlet extractor.

9. The process of claim 1 wherein the solvent is an aliphatic hydrocarbon.

10. The process of claim 1 wherein the metal-containing compound crystallizes from the solvent.
